# EUROPÄISCHE PATENTSCHRIFT

(11) **EP 1 634 039 B1**
(45) Veröffentlichungstag und Bekanntmachung des Hinweises auf die Patenterteilung: **25.04.2007**
(21) Anmeldenummer: 04728320.5
(22) Anmeldetag: 20.04.2004
(51) Int. Cl.: G01D 11/24, G01L 19/14, H01L 23/492

(54) **ACHTECK - SOCKEL FÜR STABILISIERENDE VERFÜLLUNG**
OCTAGONAL PEDESTAL FOR STABILIZING FILLING
SOCLE OCTOGONAL POUR UN REMPLISSAGE DE STABILISATION

(30) Priorität: 28.05.2003 DE 10324220
(43) Veröffentlichungstag der Anmeldung: 15.03.2006
(73) Patentinhaber: ROBERT BOSCH GMBH, 70442 Stuttgart (DE)
(72) Erfinder: SPIEGEL, Hans-Juergen, 72766 Reutlingen (DE); GROTE, Regina, 72770 Reutlingen (DE); MUEHLHEIM, Richard, 72076 Tuebingen (DE); STRATMANN, Andreas, 72810 Gomaringen (DE); MAST, Martin, 70839 Gerlingen (DE); WOERSINGER, Juergen, 75433 Maulbronn (DE)
(86) Internationale Anmeldenummer: PCT/DE2004/000822
(87) Internationale Veröffentlichungsnummer: WO 2004/109237

(56) Entgegenhaltungen:
- DE-A- 19 919 112
- US-A- 4 131 088
- US-A- 4 285 003
- US-A- 5 209 120
- US-A- 5 948 992

## Beschreibung

### Stand der Technik

Die vorliegende Erfindung geht aus von einer Vorrichtung bzw. einem Verfahren zur Herstellung der Vorrichtung, bei der wenigstens ein Gehäuse und ein mit dem Gehäuse verbundener Boden derart ausgestaltet sind, dass das Gehäuse eine Gehäusewand und der Gehäuseboden wenigstens einen Sockel aufweist. Der Rand des Sockels ist dabei so ausgestaltet, dass er wenigstens zwei Bereiche aufweist, wobei sich ein erster Bereich näher an der Gehäusewand und der zweite Bereich weiter entfernt von der Gehäusewand befindet.

Bereits aus der Patentenschrift DE 199 19 112 A1 ist eine Vorrichtung bekannt, bei der ein Drucksensor mit einem Sockel in einem Drucksensorgehäuse angeordnet ist.

### Vorteile der Erfindung

Die Erfindung geht aus von einer mikromechanische Vorrichtung mit wenigstens einem Gehäuse und einem mit dem Gehäuse verbundenen Boden. Dabei weist das Gehäuse eine Gehäusewand und der Boden wenigstens einen Sockel auf. Weiter ist vorgesehen, dass der Sockel einen vorgebbar gestalteten Rand aufweist. Der Kern der Erfindung besteht nun darin, dass der Rand des Sockel wenigstens zwei Bereiche aufweist, wobei sich ein erster Bereich des Rands näher an der Gehäusewand und ein zweiter Bereich des Rands weiter von der Gehäusewand entfernt befindet.

Besonders vorteilhaft ist es, wenn der Rand des Sockels abwechselnd aus dem ersten und dem zweiten Bereich besteht. Dabei ist insbesondere vorgesehen, dass jeweils acht erste und zweite Bereiche auf dem Sockel befinden. In einer weiteren Ausgestaltung der Erfindung ist dabei vorgesehen, dass die Anordnung der Bereiche beispielsweise zum Sockelzentrum symmetrisch über den Rand verteilt erfolgt.

Erfindungsgemäß besteht ein erster Bereich aus einer Kante, einem Winkel, einer Ecke oder einer Spitze auf den Rand des Sockels. Demgegenüber stellt der zweite Bereich eine Ebene oder eine gewölbte Fläche bezüglich der Gehäusewand auf dem Rand des Sockels dar.

In einer bevorzugten Ausgestaltung der Erfindung ist vorgesehen, das der Kontakt zwischen Gehäusewand und Sockel lediglich in einem Bereich stattfindet. Dies kann beispielsweise dadurch geschehen, dass nur der erste Bereich ein Kontakt aufweist. Weiterhin ist möglich, dass nicht jeder erste Bereich auf dem Sockel einen Kontakt zur Gehäusewand aufweist. Darüber hinaus kann vorgesehen sein, dass der Sockel als Zentriersockel ausgestaltet ist, womit eine Zentrierung des Gehäuses auf dem Gehäuseboden ermöglicht werden kann. Neben einem elektrischen Kontakt zwischen Gehäusewand und Sockel kann weiterhin auch ein thermischer Kontakt berücksichtigt werden.

Bei der Ausgestaltung des Sockels auf dem Gehäuseboden ist vorteilhafterweise vorgesehen, dass sich wenigstens im zweiten Bereich zwischen dem Sockel und der Gehäusewand ein Zwischenraum befindet. In diesem Zwischenraum ist in einer besonderen Ausgestaltung der Erfindung einen Verfüllungsmaterial vorgesehen, welches den Zwischenraum vollständig ausfüllt. Darüber hinaus ist vorgesehen, dass der Zwischenraum zwischen dem Rande des Sockels und der Gehäusewand mit dem Verfüllungsmaterial wenigstens teilweise aufgefüllt wird. Weiterhin ist vorgesehen, dass als Verfüllungsmaterial ein Passivierungsstoff verwendet wird.

Besonders vorteilhaft ist es, wenn der erste und der zweite Bereich des Randes des Sockels so ausgestaltet sind, dass eine Verfüllung des als Verfüllbereichs ausgestalteten Zwischenraums zwischen dem Rand des Sockels und der Gehäusewand mit einem Minimum an Einschlüssen von Luft- und/oder Hohlräumen in dem Verfüllungsmaterial erreicht wird. Die Gestaltung des ersten und zweiten Bereichs des Randes des Sockels kann dabei über die Ausdehnungen der beiden Bereiche variiert werden. Eine weitere Möglichkeit die Einschlüsse zu minimieren besteht darin, die Abfolge des ersten und des zweiten Bereichs entsprechend aufeinander abzustimmen.

Erfindungsgemäß ist vorgesehen, dass das Verfüllungsmaterial zwischen dem Rand des Sockels und der Gehäusewand wenigstens bis zur Sockelhöhe eingebracht ist. Darüber hinaus kann vorgesehen seien, dass auch Teile der Oberseite des Sockels mit dem Verfüllungsmaterial bedeckt werden. Dies kann beispielsweise vorteilhaft zur Fixierung der Kontakte eines Sensorelements sein.

In einer Weiterbildung der Erfindung weist der Boden wenigstens ein Sensorelement auf, welches eine Betriebsgröße erfasst, die wenigstens einen Betriebsparameter eines an das Sensorelement angrenzenden Mediums und/oder einen Zustandsparameter das Sensorelements repräsentiert. Dabei ist insbesondere vorgesehen, dass sich das Sensorelement im Bereich des Sockels befindet. Werden Betriebsparameter eines Mediums erfasst, so ist vorgesehen, dass das Sensorelement dem Medium ausgesetzt ist. Somit kann ein Druck und/oder einer Druckdifferenz und/oder eine Temperatur und/oder eine Dichte und/oder eine Strömungsgeschwindigkeit des Mediums erfasst werden. Soll eine Zustandsgröße das Sensorelement erfasst werden, so ist ein direkter Kontakt mit einem das Sensorelement umgebenden Mediums nicht zwingend notwendig. Zustandsgröße wie beispielsweise eine Geschwindigkeit und/oder eine Beschleunigung und/oder eine Drehbewegung und/oder eine Drehbewegung können daher unmittelbar durch das Sensorelement erfasst werden.

Weitere Vorteile ergeben sich aus der nachfolgenden Beschreibung von Ausführungsbeispielen bzw. aus den abhängigen Patentansprüchen.

### Zeichnungen

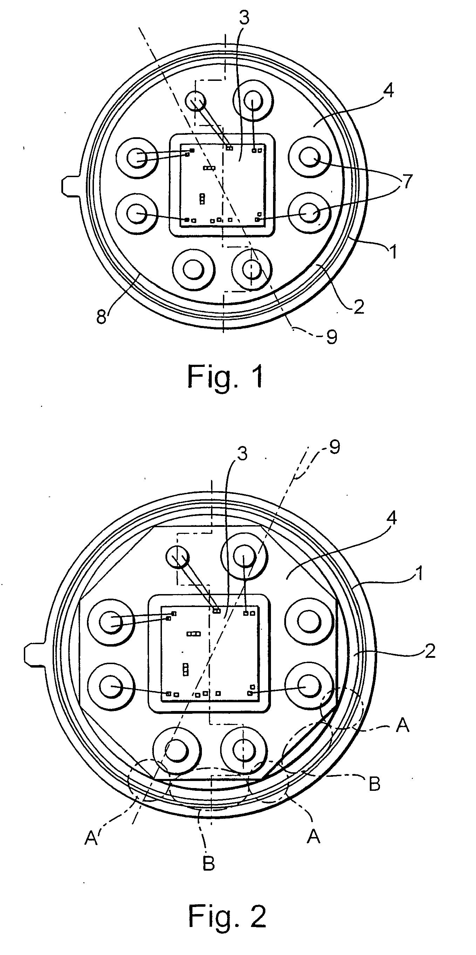

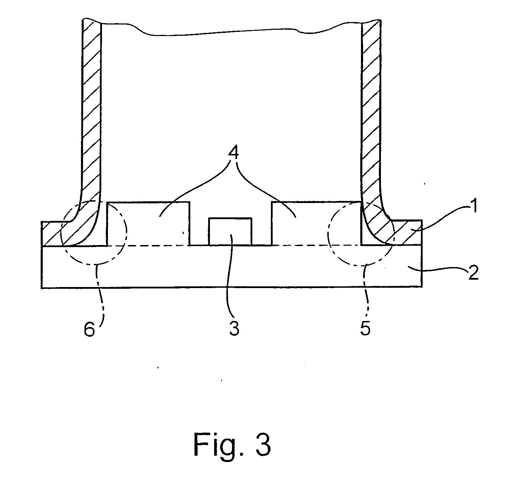

Figur 1 zeigt die Aufsicht auf einen herkömmlichen Sockel einer Gehäuseform zur Aufnahme eines mikromechanischen Bauelements. Figur 2 zeigt die Aufsicht auf einen gemäß der Erfindung modifizierten Sockel. In Figur 3 ist ein Querschnitt durch das Gehäuse, den mit dem Gehäuse verbundenen Boden und den Sockel dargestellt.

### Ausführungsbeispiele

Anhand der Zeichnungen soll im folgenden ein Ausführungsbeispiel beschrieben werden, bei dem die Vorteile der erfindungsgemäßen Gestaltung des Sockels einer Gehäuseform dargestellt werden. Typischerweise werden derartige Gehäuseformen als Gehäuse für Sensoren verwendet.

In Figur 1 ist die Aufsicht eines herkömmlichen Sockels 4 zu erkennen, der sich auf einem Gehäuseboden 2 befindet. Das Sensorelement 3 sitzt dabei zentral in dem Sockel 4. Eine Kontaktierung des Sensorelements 3 findet über Stifte 7 durch den Sockel 4 statt. Die Zentrierung des Gehäusedeckels 1 erfolgt umlaufend am Sockelrand 8.

Ein Querschnitt 9 durch den Gehäusedeckel 1, den Gehäuseboden 2 und den Sockel 4 ist in Figur 3 gezeigt. Dabei ist zu erkennen, dass der Gehäusedeckel 1 mit dem Gehäuseboden 2 verbunden ist. Eine Zentrierung das Gehäusedeckels 1 auf dem Gehäuseboden 2 findet über die Führung der Gehäusewand am Sockel 4 des Gehäusebodens 2 statt. Durch Toleranzen bei der Herstellung des Gehäusedeckels 1 und des Sockels 4 kann der Abstand zwischen Gehäusewand und Sockel 4 über den gesamten Verlauf des Sockelrandes ungleichmäßig breit ausfallen. Es ist jedoch nicht wie in Figur 1 gezeigt wird zwingend notwendig, dass die Gehäusewand über den gesamten Sockelrand einen Kontakt zum Sockel 4 aufweist. Erfindungsgemäß sind lediglich einige wenige Kontaktpunkte zwischen Sockel 8 und Gehäusewand erforderlich, wie in Figur 2 am Beispiel eines 8-eckigen Sockels 4 dargestellt ist, um eine Zentrierung zu erreichen.

In einer besonderen Ausführungsform der Erfindung nach Figur 2 ist der Rand des Sockels 4 derart ausgestaltet, dass sich die ersten Bereiche A näher an der Gehäusewand und die zweiten Bereiche B weiter entfernt von der Gehäusewand befinden. In der Figur 2 sind die ersten Bereiche A als Ecken in dem Sockel 4 ausgebildet, wobei auch andere Ausgestaltung der ersten Bereiche A denkbar sind. Eine Zentrierung des Gehäusedeckels 1 findet dabei über ausgewählte Kontaktpunkte in den ersten Bereichen A statt. Deutlich ist in Figur 2 im Vergleich zur Figur 1 zu erkennen, dass zwischen den Kontaktpunkten in den ersten Bereichen A definierte freie Volumina zwischen Gehäusewand und Sockel 4 entstehen. Diese freien Volumina erleichtern eine Befüllung des Zwischenraums zwischen Rand und Gehäusewand mit Verfüllmaterial.

Wie der Querschnitt 9 in Figur 3 weiterhin zeigt, entstehen bei der Verbindung des Gehäusedeckels mit dem Gehäuseboden zwischen Gehäusewand und Sockel 4 bzw. Gehäuseboden 2 Taschen 5 und 6. Wird beispielsweise zur Stabilisierung der Verbindung Gehäusedeckel 1 und Gehäuseboden 2 ein Verfüllmaterial eingebracht, so können bei der Bildung dieser Taschen 5 und 6 bei einer Ausgestaltung des Sockels 4 nach Figur 1 Einschlüsse von Luft- und/oder Hohlräumen nicht vermieden werden. Wird der Sockel 4 jedoch erfindungsgemäß nach Figur 2 gestaltet, so kann das Verfüllungsmaterial, welches beispielsweise von oben zwischen Gehäusewand und Sockel 4 bzw. Gehäuseboden 2 eingebracht wird, auch diese Stellen erreichen, indem die ansonsten von oben nicht zugänglichen Taschen 5 von der Seite ausgefüllt werden.

Als Sensortypen, bei denen die erfindungsgemäße Ausgestaltung des Sockels (4) angewandt werden kann, eigenen sich Drucksensoren, thermische Sensoren, Massenflusssensoren, aber auch Beschleunigungssensoren, Gierratensensoren oder Drehzahlsensoren. Da je nach Sensortyp ein direkter Kontakt des Sensorelements (3) zu dem den Sensor umgebenden Mediums erfolgen muss, kann im Gehäusedeckel 1 eine entsprechende Öffnung vorgesehen sein.

## Patentansprüche

1. Vorrichtung mit wenigstens
- einem Gehäuse (1) und
- einem mit dem Gehäuse (1) verbundenen Boden (2),
wobei
- das Gehäuse (1) eine Gehäusewand aufweist und
- der Boden (2) wenigstens einen Sockel (4) aufweist und
- der Sockel (4) einen Rand aufweist
**dadurch gekennzeichnet, dass**
der der Gehäusewand naheliegende Rand des Sockels derart ausgestaltet ist, dass der Rand des Sockels (4) wenigstens zwei Bereiche aufweist, wobei
- sich ein erster Bereich (A) des Rands näher an der Gehäusewand befindet und
- ein zweiter Bereich (B) des Rands weiter von der Gehäusewand entfernt ist.

2. Vorrichtung nach Anspruch 1, **dadurch gekennzeichnet, dass** der Rand des Sockels (4) abwechselnd aus dem ersten Bereich (A) und dem zweiten Bereich (B) besteht, wobei insbesondere vorgesehen ist, dass
- der Rand des Sockels (4) jeweils acht erste Bereiche (A) und acht zweite Bereiche (B) aufweist und/oder
- die Bereiche symmetrisch zum Sockelzentrum auf dem Rand des Sockels (4) angeordnet sind.

3. Vorrichtung nach Anspruch 1, **dadurch gekennzeichnet, dass**
- der erste Bereich (A)
- eine Kante,
- einen Winkel,
- eine Ecke oder
- eine Spitze
und/oder
- der zweite Bereich (B)
- eine ebene oder
- eine gewölbte
Fläche
bezüglich der Gehäusewand auf dem Rand des Sockels (4) darstellt.

4. Vorrichtung nach Anspruch 1, **dadurch gekennzeichnet, dass** ein direkter Kontakt zwischen der Gehäusewand und dem Sockel (4) lediglich in wenigstens einem ersten Bereich (A) stattfindet, wobei insbesondere vorgesehen ist, dass der Sockel (4) als Zentriersockel ausgestaltet ist.

5. Vorrichtung nach Anspruch 1, **dadurch gekennzeichnet, dass** sich wenigstens Zwischen dem Sockel (4) und der Gehäusewand ein Verfüllbereich befindet, wobei insbesondere vorgesehen ist, dass wenigstens dieser Verfüllbereich mit einem Verfüllungsmaterial aufgefüllt ist, wobei insbesondere vorgesehen ist, dass das Verfüllungsmaterial einen Passivierungsstoff darstellt.

6. Vorrichtung nach Anspruch 5, **dadurch gekennzeichnet, dass**
- der erste Bereich (A) und der zweite Bereich (B) des Randes des Sockels (4) derart gestaltet sind und/oder
- die Abfolge des ersten Bereichs (A) und des zweiten Bereichs (B) so gewählt ist, dass eine Verfüllung des Verfüllbereichs zwischen dem Rand des Sockels (4) und der Gehäusewand ein Minimum an Einschlüssen von Luft- und/oder Hohlräumen aufweist.

7. Vorrichtung nach Anspruch 5, **dadurch gekennzeichnet, dass** das Verfüllungsmaterial wenigstens teilweise den Sockel (4) bedeckt, wobei insbesondere vorgesehen ist, dass das Verfüllungsmaterial über die Bedeckung des Randes des Sockels (4) auch einen Teil der Oberseite des Sockels (4) bedeckt.

8. Vorrichtung nach Anspruch 1, **dadurch gekennzeichnet, dass** der Boden (2) ein Sensorelement (3) aufweist, welches eine Betriebsgröße erfasst, welche wenigstens
- einen Betriebsparameter eines an das Sensorelement (3) angrenzenden Mediums und/oder
- einen Zustandsparameter des Sensorelements (3)
repräsentiert, wobei insbesondere
- als Betriebsparameter
- ein Druck, und/oder
- eine Druckdifferenz, und/oder
- eine Temperatur, und/oder
- eine Dichte, und/oder
- eine Strömungsgeschwindigkeit
und
- als Zustandsgröße
- eine Geschwindigkeit, und/oder
- eine Beschleunigung, und/oder
- eine Drehbewegung, und/oder
- eine Gierbewegung
vorgesehen ist.

9. Verfahren zur Herstellung einer Vorrichtung, insbesondere einer Vorrichtung nach Anspruch 1 bis 8, mit wenigstens
- einem Gehäuse (1) und
- einem Boden (2),
wobei
- das Gehäuse (1) eine Gehäusewand aufweist und
- der Boden (2) wenigstens einen Sockel (4) aufweist und
- der Sockel (4) einen Rand aufweist und
**dadurch gekennzeichnet, dass**
der der Gehäusewand naheliegende Rand des Sockels derart ausgestaltet ist, dass der Rand des Sockels (4) wenigstens zwei Bereiche aufweist, wobei
- sich ein erster Bereich (A) des Rands näher an der Gehäusewand befindet und
- ein zweiter Bereich (B) des Rands weiter von der Gehäusewand entfernt ist.

10. Verfahren nach Anspruch 9, **dadurch gekennzeichnet, dass** sich wenigstens zwischen im zweiten Bereich (B) zwischen dem Sockel (4) und der Gehäusewand ein Verfüllbereich befindet, wobei insbesondere vorgesehen ist, dass wenigstens dieser Verfüllbereich mit einem Verfüllungsmaterial aufgefüllt wird, wobei insbesondere vorgesehen ist, dass das Verfüllungsmaterial einen Passivierungsstoff darstellt.

11. Verfahren nach Anspruch 9, **dadurch gekennzeichnet, dass**
- der erste Bereich (A) und der zweite Bereich (B) des Randes des Sockels (4) derart gestaltet werden und/oder
- die Abfolge des ersten Bereichs (A) und des zweiten Bereichs (B) so gewählt wird, dass eine Verfüllung des Verfüllbereichs zwischen dem Rand des Sockels (4) und der Gehäusewand mit einem Mindestmaß an Einschlüssen von Luft- und/oder Hohlräumen erreicht wird.

## Claims

1. Apparatus having at least
- one housing (1) and
- one base (2) which is connected to the housing (1),
with
- the housing (1) having a housing wall and
- the base (2) having at least one cap (4), and
- the cap (4) having a rim
**characterized in that**
the rim of the cap close to the housing wall is designed in such a manner that the rim of the cap (4) has at least two areas, with
- a first area (A) of the rim being located closer to the housing wall and
- a second area (B) of the rim being further away from the housing wall.

2. Apparatus according to Claim 1, **characterized in that** the rim of the cap (4) comprises the first area (A) and the second area (B) alternately, in particular with provision being made that
- the rim of the cap (4) in each case has eight first areas (A) and eight second areas (B), and/or
- the areas are arranged symmetrically with respect to the cap centre on the rim of the cap (4).

3. Apparatus according to Claim 1, **characterized in that**
- the first area (A) represents
- an edge,
- an angle,
- a corner or
- a tip
and/or
- the second area (B) represents
- a flat or
- a curved
surface
with respect to the housing wall on the rim of the cap (4).

4. Apparatus according to Claim 1, **characterized in that** direct contact between the housing wall and the cap (4) takes place only in at least one first area (A), in particular with provision being made that the cap (4) is in the form of a centring cap.

5. Apparatus according to Claim 1, **characterized in that** a filling area is located at least between the cap (4) and the housing wall, with provision being made in particular that at least this filling area is filled with filling material, in particular with provision being made that the filling material represents a passivation substance.

6. Apparatus according to Claim 5, **characterized in that**
- the first area (A) and the second area (B) of the rim of the cap (4) are designed in such a manner and/or
- the sequence of the first area (A) and of the second area (B) is chosen such
that any filling of the filling area between the rim of the cap (4) and the housing wall has a minimum of air enclosures and/or cavities.

7. Apparatus according to Claim 5, **characterized in that** the filling material at least partially covers the cap (4) in particular with provision being made that the filling material covering the rim of the cap (4) also covers a part of the upper face of the cap (4).

8. Apparatus according to Claim 1, **characterized in that** the base (2) has a sensor element (3) which detects an operating variable which represents at least
- one operating parameter of a medium which is adjacent to the sensor element (3) and/or
- one state parameter of the sensor element(3), in particular with
- a pressure, and/or
- a pressure difference, and/or
- a temperature, and/or
- a density, and/or
- a flow rate
being provided as an operating parameter
and
- a speed, and/or
- an acceleration, and/or
- a rotary movement, and/or
- a yawing movement
being provided as a state variable.

9. Method for production of an apparatus, in particular, apparatus according to Claims 1 to 8, having at least
- one housing (1) and
- one base (2),
with
- the housing (1) having a housing wall and
- the base (2) having at least one cap (4), and
- the cap (4) having a rim
**characterized in that**
the rim of the cap close to the housing wall is designed in such a manner that the rim of the cap (4) has at least two areas, with
- a first area (A) of the rim being located closer to the housing wall and
- a second area (B) of the rim being further away from the housing wall.

10. Method according to Claim 9, **characterized in that** a filling area is located at least between the cap (4) and the housing wall in the second area (B) in particular with provision being made that at least this filling area is filled with a filling material, in particular with provision being made that the filling material represents a passivation substance.

11. Method according to Claim 9, **characterized in that**
- the first area (A) and the second area (B) of the rim of the cap (4) are designed in such a manner and/or
- the sequence of the first area (A) and of the second area (B) is chosen such
that any filling of the filling area between the rim of the cap (4) and the housing wall has a minimum of air enclosures and/or cavities.

## Revendications

1. Dispositif comportant au moins
- un boîtier (1) et
- un fond (2) relié au boîtier (1),
dans lequel
- le boîtier (1) présente une paroi de boîtier,
- le fond (2) présente au moins un socle (4) et
- le socle (4) présente un bord,
**caractérisé en ce que**
le bord du socle adjacent à la paroi de boîtier est formé de telle manière que le bord du socle (4) présente au moins deux zones, dans lequel
- une première zone (A) du bord se trouve plus près de la paroi de boîtier, et
- une seconde zone (B) du bord est plus éloignée encore de la paroi de boîtier.

2. Dispositif selon la revendication 1,
**caractérisé en ce que**
le bord du socle (4) se compose en alternance de la première zone (A) et de la seconde zone (B), en prévoyant en particulier que
- le bord du socle (4) présente respectivement huit premières zones (A) et huit secondes zones (B) et/ou
- les zones sont agencées sur le bord du socle (4) symétriquement par rapport au centre du socle.

3. Dispositif selon la revendication 1,
**caractérisé en ce que**
- la première zone (A) représente
- une arête,
- un angle,
- un coin ou
- une extrémité
et/ou
- la seconde zone (B) représente
- une surface plate ou
- une surface voûtée
par rapport à la paroi de boîtier sur le bord du socle (4).

4. Dispositif selon la revendication 1,
**caractérisé en ce qu'**
un contact direct a lieu entre la paroi de boîtier et le socle (4) seulement dans au moins une première zone (a), et en particulier le socle est formé comme socle de centrage (4).

5. Dispositif selon la revendication 1,
**caractérisé en ce qu'**
au moins une zone de remplissage se trouve entre le socle (4) et la paroi de boîtier, et en particulier au moins cette zone de remplissage est remplie d'un matériau de remplissage, notamment une matière de passivation.

6. Dispositif selon la revendication 5,
**caractérisé en ce que**
- la première zone (A) et la seconde zone (B) du bord du socle (4) sont formées de telle manière, et/ou
- l'ordre de la première zone (A) et de la seconde zone (B) est choisi de telle sorte
- qu'un remplissage de la zone de remplissage entre le bord du socle (4) et la paroi de boîtier présente un minimum d'inclusions d'espaces remplis d'air et/ou d'espaces creux.

7. Dispositif selon la revendication 5,
**caractérisé en ce que**
le matériau de remplissage couvre au moins en partie le socle (4), et en particulier le matériau de remplissage couvre également une partie de la face supérieure du socle (4) par dessus la couverture du bord du socle (4).

8. Dispositif selon la revendication 1,
**caractérisé en ce que**
le fond (2) présente un élément capteur (3) qui détecte une grandeur de fonctionnement réprésentant au moins :
- un paramètre de fonctionnement d'un fluide adjacent à l'élément capteur (3) et/ou
- un paramètre d'état de l'élément capteur (3),
et en particulier
le paramètre de fonctionnement est :
- une pression, et/ou
- une différence de pression, et/ou
- une température, et/ ou
- une densité, et/ou
- une vitesse d'écoulement
et
le paramètre d'état est :
- une vitesse, et/ou
- une accélération, et/ou
- un mouvement de rotation, et/ ou
- un mouvement de lacet.

9. Procédé de fabrication d'un dispositif, en particulier d'un dispositif selon la revendication 1 à 8, comportant au moins
- un boîtier (1) et
- un fond (2),
dans lequel
- le boîtier (1) présente une paroi de boîtier,
- le fond (2) présente au moins un socle (4) et
- le socle (4) présente un bord,
**caractérisé en ce que**
le bord du socle adjacent à la paroi de boîtier est formé de telle manière que le bord du socle (4) présente au moins deux zones,
- une première zone (A) du bord se trouvant plus près de la paroi de boîtier, et
- une seconde zone (B) du bord plus éloignée encore de la paroi de boîtier.

10. Procédé selon la revendication 9,
**caractérisé en ce qu'**
une zone de remplissage est au moins intermédiaire dans la seconde zone (B) entre le socle (4) et la paroi de boîtier, en particulier au moins cette zone de remplissage est remplie d'un matériau de remplissage, notamment une matière de passivation.

11. Procédé selon la revendication 9,
**caractérisé en ce que**
- la première zone (A) et la seconde zone (B) du bord du socle (4) sont formés de telle manière, et/ou
- l'ordre de la première zone (A) et de la seconde zone (B) est choisi de telle sorte
- qu'un remplissage de la zone de remplissage entre le bord du socle (4) et la paroi de boîtier soit obtenu avec un minimum d'inclusions d'espaces remplis d'air et/ou d'espaces creux.
